Europäisches Patentamt

European Patent Office

Office européen des brevets

(11) Publication number: **0 175 375**
A2

## EUROPEAN PATENT APPLICATION

(21) Application number: 85111902.4

(22) Date of filing: 20.09.85

(51) Int. Cl.⁴: **H 04 M 1/10**

(30) Priority: 21.09.84 JP 198260/84

(43) Date of publication of application: 26.03.86
**Bulletin 86/13**

(84) Designated Contracting States: **DE FR GB**

(71) Applicant: **Kabushiki Kaisha Toshiba, 72, Horikawa-cho Saiwai-ku, Kawasaki-shi Kanagawa-ken 210 (JP)**

(72) Inventor: **Noshio, Koji, 4-14-7, Oosawa, Mitaka-shi Tokyo-To (JP)**
Inventor: **Shirai, Yasuo, 2-4-10, Mishuku Setagaya-Ku, Tokyo-To (JP)**
Inventor: **Shiramatsu, Toshio, 42, Naka-Kibogaoka Asahi-Ku, Yokohama-Shi Kanagawa-Ken (JP)**

(74) Representative: **Lehn, Werner, Dipl.-Ing. et al, Hoffmann, Eitle & Partner Patentanwälte Arabellastrasse 4 (Sternhaus), D-8000 München 81 (DE)**

(54) Telephone.

(57) In a telephone comprising a transmitter (1) for converting an input sound into an input electrical signal, a transforming means (3) for transforming the input signal, and a line driver (5) for transmitting a signal transformed by the transforming means (3) to a telephone line (6a, 6b), the telephone further comprises a detector (2) for detecting a voltage level of the input signal, and a comparator (4) for comparing the voltage level of the input signal with a predetermined reference voltage level to output a result of the comparison, and the transforming means (3) transforms the input signal at a first transformation factor when the result of the comparison represents that the input signal level is lower than the predetermined reference voltage level, and at a second transformation factor which is larger than the first transformation factor when the result of the comparison represents that the input signal level is not lower than the predetermined reference voltage level. The telephone can transmit only the signal according to speaker's speech and have a high speech quality.

TELEPHONE

BACKGROUND OF THE INVENTION

The present invention relates to a telephone and, more particularly, to a transmitting circuit of the telephone.

In a conventional telephone, a transmitter receives an input sound to convert it into an input electrical signal, and an amplifier amplifies the input electrical signal. The amplified signal is transmitted to a telephone line. A recent telephone uses an extremely sensitive transmitter, such as an electret microphone type transmitter and a ceramic microphone type transmitter. The transmitter can receive not only speaker's speech but also a small noise. Thus the input electrical signal according to a small noise is also amplified and transmitted to a telephone line. This results in the problem that the signal according to the small noise disturbs speaker's speech and is annoying to the listener.

SUMMARY OF THE INVENTION

An object of the present invention is to provide a telephone which can transmit only the signal according to speaker's speech and have a high speech quality.

To achieve this object, the present invention provides a telephone comprising: means for converting an input sound into an input electrical signal; means for detecting a voltage level of said input signal; means for comparing said voltage level of the input signal with a predetermined reference voltage level to output a result of the comparison; means for transforming said input signal at a first transformation factor when said result of the comparison represents that said input signal level is lower than said predetermined reference voltage level, and at a second transformation factor which is larger than said first transformation factor when said result of the comparison represents that said input signal level is not lower than said predetermined reference voltage level; and means for transmitting a signal transformed by said transforming means to a telephone line.

## BRIEF DESCRIPTION OF THE DRAWINGS

In the accompanying drawings:

FIG. 1 is a block diagram showing a transmitting circuit of a telephone according to a first embodiment of the present invention;

FIG. 2 is a graph showing a characteristic of the transmitting circuit;

FIG. 3 is a graph showing a characteristic of a conventional transmitting circuit;

FIG. 4 is a block diagram showing a transmitting circuit of a telephone according to a second embodiment of the present invention;

FIG. 5 is a block diagram showing a transmitting circuit of a telephone according to a third embodiment of the present invention;

FIG. 6 is a block diagram showing a transmitting circuit of a telephone according to a fourth embodiment of the present invention;

FIG. 7 is a circuit diagram showing a main part of a transmitting circuit of a telephone according to a fifth embodiment of the present invention; and

FIG. 8 is a graph showing a characteristic of the transmitting circuit.

## DETAILED DESCRIPTION OF THE INVENTION

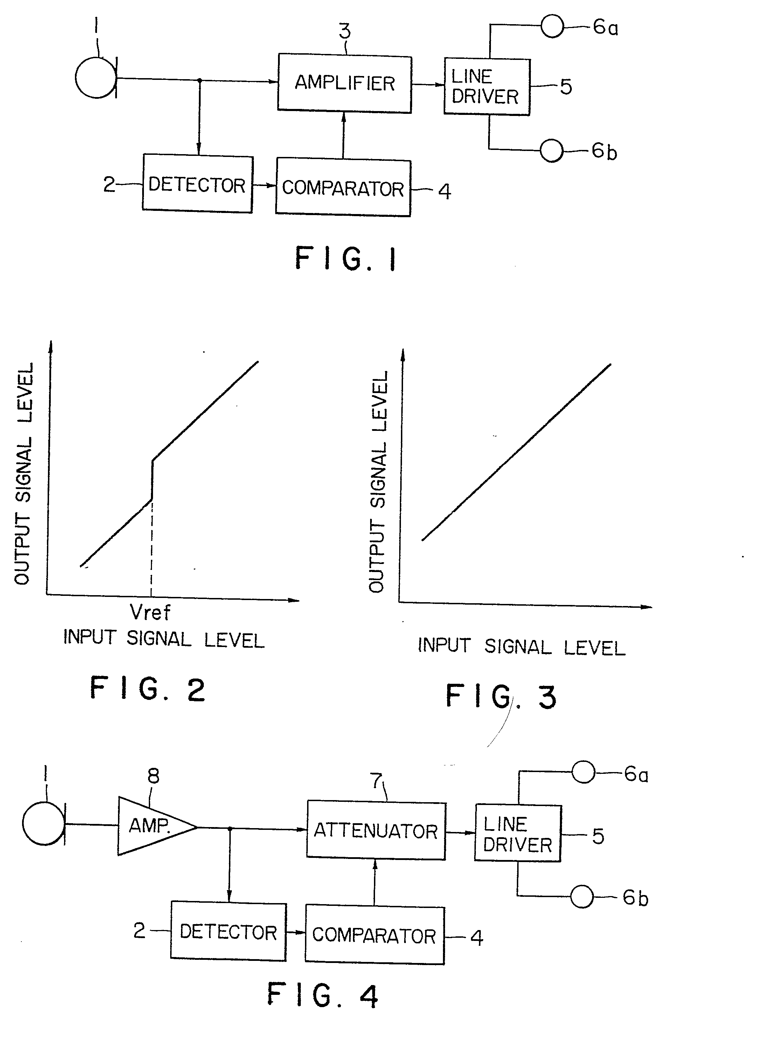

FIG. 1 shows a transmitting circuit of a telephone according to a first embodiment of the present invention. A transmitter 1 converts an input sound to an electrical signal. When the transmitter 1 receives an input sound, such as speaker's speech and a noise, the transmitter 1 outputs the input signal according to the input sound. The input signal is inputted to a detector 2 and an amplifier 3. The detector 2 detects a voltage level of the input signal to output the voltage level signal to a comparator 4. The comparator 4 compares the voltage level with a predetermined reference voltage level to output a result of the comparison to an amplifier 3. It is desirable that the predetermined reference voltage level is lower than the minimum level of speaker's speech and higher than the level of a noise which the transmitter 1 may receive.

The amplifier 3 amplifies the input signal at an amplification factor which varies depending on the result of the comparison. Specifically, when the voltage level of the input signal is lower than the reference voltage level, the amplifier 3 amplifies the input signal at a low amplification factor. When the voltage level of the input signal is not lower than the reference voltage level, the amplifier 3 amplifies the input signal at a high amplification factor. Therefore, the amplifier 3 has a relationship between an input signal level and an output signal level as shown in FIG. 2. For comparison, FIG. 3 shows a relationship between an input signal level and an output signal level of an amplifier used in a conventional transmitting circuit. In FIGS. 2 and 3, these signals are shown on a log scale. A line driver 5 transmits the output signal of the amplifier 3 to telephone lines 6a, 6b.

As stated above, the present embodiment makes it possible to improve a speech quality of the telephone. This is because a small input sound like a noise is amplified at the low amplification factor not to be transmitted to the telephone line and only the large input sound like speaker's speech is amplified at the high amplification factor to be transmitted to the telephone line.

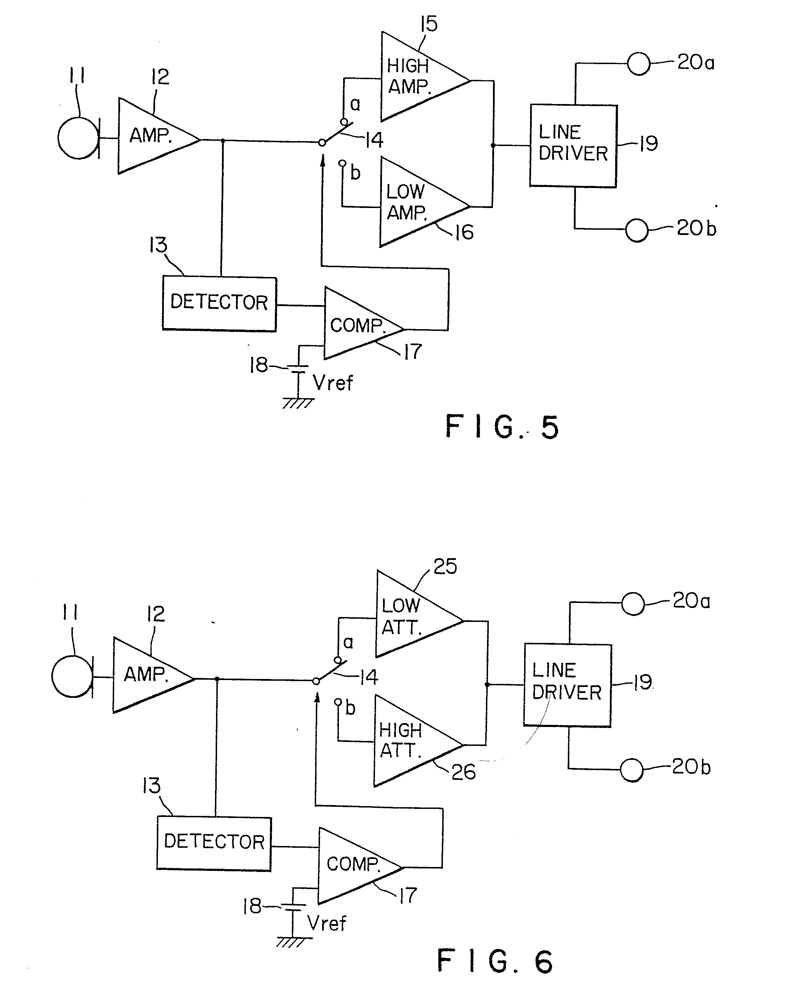

FIG. 5 shows a transmitting circuit of a telephone according to a second embodiment of the present invention. The transmitting circuit uses an attenuator 7 instead of the amplifier 3 and further comprises an amplifier 8 connected to the transmitter 1. The attenuator 7 attenuates an output signal of the amplifier 8. The attenuator 7 attenuates the output signal
at an attenuation factor which varies depending on
the result of the comparison of the comparator 4.
Specifically, when the voltage level of the output
signal of the amplifier 8 is lower than the reference
voltage level, the attenuator 7 attenuates the output
signal at a high attenuation factor. When the voltage
level of the output signal is not lower than the
reference voltage level, the attenuator 7 attenuates
the output signal at a lower attenuation factor or
does not attenuate the output signal. Therefore, the
attenuator 7 has a relationship between an input signal
level and an output signal level as shown in FIG. 2.

    As stated above, the present embodiment makes it
possible to improve a speech quality of the telephone.
This is because the small input sound like a noise is
attenuated at the high attenuation factor not to be
transmitted to the telephone line and only the large
input sound like speaker's speech is attenuated at the
low attenuation factor to be transmitted to the telephone line.

    FIG. 5 shows a transmitting circuit of a telephone
according to a third embodiment of the present invention. A transmitter 11 converts an input sound to an
input electrical signal. The converted input signal
is amplified by an amplifier 12 and outputted to a
detector 13 and a switch 14. The detector 13 detects
a voltage level of the input signal to generate a direct-
current voltage signal which is proportional to an
amplitude of the amplified input signal. The direct-
current voltage signal is inputted to one terminal of a
comparator 17. The other terminal of the comparator 17
is connected to a reference voltage supply 18. The
comparator 17 compares the output signal of the detector
13 with the reference voltage of the supply 18 to output
the result of the comparison to the switch 14.

When the result of the comparison represents that the output signal of the detector 13 is larger than the reference voltage, an input terminal of the switch 14 is connected to an output terminal a. Thus the output signal of the amplifier 12 is amplified by a high gain amplifier 15 having a high amplification factor. The amplified signal is transmitted to telephone lines 20a and 20b by a line driver 19.

When the result of the comparison represents that the output signal of the detector 13 is not larger than the reference voltage, the input terminal of the switch 14 is connected to an output terminal b. Thus the output signal of the amplifier 12 is amplified by a low gain amplifier 16 having a low amplification factor. The amplified signal is transmitted to telephone lines 20a and 20b by a line driver 19.

As stated above, the transmitting circuit of the telephone according to the present embodiment has the characteristic as shown in FIG. 2 by switching selectively the high gain amplifier 15 or the low gain amplifier 16 on the basis of the result of the comparison.

FIG. 6 shows a transmitting circuit of a telephone according to a fourth embodiment of the present invention. The transmitting circuit uses an attenuator 25 instead of the high gain amplifier 15 and an attenuator 26 instead of the low gain amplifier 16. The attenuator 25 has a low attenuation factor, and the attenuator 26 has a high attenuation factor. The transmitting circuit of the telephone according to the present embodiment has the characteristic as shown in FIG. 2 by switching selectively the attenuator 25 with the low attenuation factor or the attenuator 26 with the high attenuation factor on the basis of the result of the comparison.

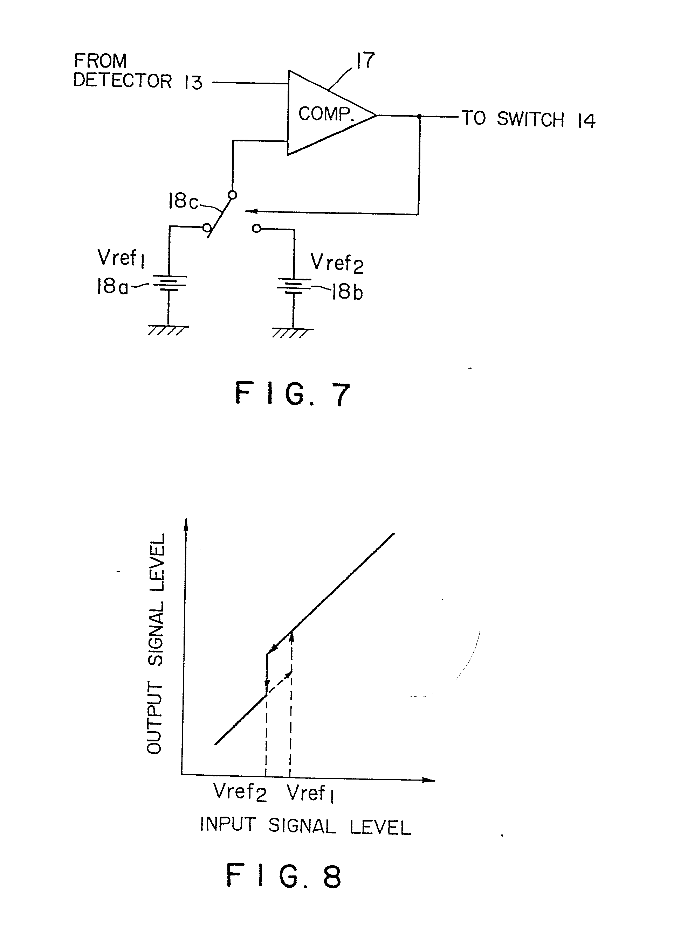

FIG. 7 shows a main part of a transmitting circuit of a telephone according to a fifth embodiment of the present invention. The transmitting circuit uses a high reference voltage supply 18a, a low reference voltage supply 18b, and a switch 18c instead of the reference voltage supply 18. The high reference voltage supply 18a produces a high reference voltage $V_{ref1}$ and the low reference voltage supply 18b produces a low reference voltage $V_{ref2}$. The switch 18c has one input terminal connected to the supply 18a, the other input terminal connected to the supply 18b, and an output terminal connected to the comparator 17. The switch 18c selectively connects the output terminal to the one input terminal or the other input terminal in accordance with the result of the comparison of the comparator 17.

The transmitting circuit according to the present embodiment has a "hysteresis characteristic" by which the reference voltage level varies in accordance with the direction of the change of the output signal of the detector 13, as shown in FIG. 8. The "hysteresis characteristic" will be discussed more specifically as below. When the output signal of the detector 13 is zero or very small, the switch 18c connects the output terminal to the one input terminal connected to the supply 18a. Thus the high reference voltage $V_{ref1}$ is supplied to the comparator 17. When the output signal increases to exceed the reference voltage $V_{ref1}$, the switch 18c connects the output terminal to the other input terminal connected to the supply 18b. Thus the low reference voltage $V_{ref2}$ is supplied to the comparator 17. Now the comparator 17 compares the output signal with the low reference voltage $V_{ref2}$. Therefore, even if the output signal decreases to be lower than the high reference voltage $V_{ref1}$, the result of the comparison does not change. When the output signal further decreases to be lower than the low reference voltage $V_{ref2}$, the switch 18c connects the output terminal to the one input terminal connected to the supply 18b.

As stated above, the present embodiment makes it possible to improve a speech quality of the telephone. When the input sound is very small like a small noise, the reference voltage level is high. Thus, a small noise is not transmitted to the telephone line. On the contrary, when a large input sound like speaker's speech is supplied, the reference voltage level becomes low.

Thus, even if speaker's voice becomes small, the speaker's speech is still amplified at a high amplification factor to be transmitted to the telephone line.

The present invention may be practiced or embodied in still other ways without departing from the spirit or essential character thereof. For instance, while in FIGs. 2 and 8, the relationship between the input signal and the output signal of the amplifier is represented by a direct line, the relationship may alternately be represented by a curved line. Also the transmitter can be replaced by another type transmitter, such as an electret microphone type transmitter, a ceramic microphone type transmitter, and a carbon microphone type transmitter.

As stated above, the present invention makes it possible to transmit only the signal according to speaker's speech and have a high speech quality.

Claims:

1.      A telephone comprising means (1;11) for con-
verting an input sound into an input electrical signal,
means (3;7) for transforming said input signal, and
means (5;19) for transmitting a signal transformed by
said transforming means (3;7) to a telephone line
(6a,6b; 20a,20b), characterized in that said telephone
comprises means (2;13) for detecting a voltage level
of said input signal, and means (4;17,18) for comparing
said voltage level of the input signal with a predetermined reference voltage level to output a result of the
comparison, and that said transforming means (3;7)
transforms said input signal at a first transformation
factor when said result of the comparison represents that
said input signal level is lower than said predetermined
reference voltage level, and at a second transformation
factor which is larger than said first transformation
factor when said result of the comparison represents
that said input signal level is not lower than said predetermined reference voltage level.

2.      A telephone according to claim 1, wherein said
transforming means comprises means (3) for amplifying
said input signal.

3.      A telephone according to claim 1, wherein said
transforming means comprises means (7) for attenuating
said input signal.

4.      A telephone according to claim 1, wherein said
transforming means comprises:
        a switch (14) having an input terminal inputting said input signal, a first output terminal,
and a second output terminal, said switch connecting
said input terminal to either of said first output
terminal and said second output terminal in accordance
with said result of the comparison;

a first transforming means (15;25) having an input terminal connected to said first output terminal of said switch, said first transforming means transforming said input signal at said first transformation factor; and

a second transforming means (16;26) having an input terminal connected to said second output terminal of said switch, said second transforming means transforming said input signal at said second transformation factor.

5.     A telephone according to claim 4, wherein each of said first and second transforming means comprises means (15,16) for amplifying said input signal.

6.     A telephone according to claim 4, wherein each of said first and second tranforming means comprises means (25,26) for attenuating said input signal.

7.     A telephone according to any of claims 1 to 6, wherein said comparing  means has a hysteresis characteristic by which said predetermined reference voltage level varies in accordance with the direction of the change of said input signal.

8.     A telephone according to claim 7, wherein said telephone further comprises:
        means (18b) for producing a first voltage level;
        means (18a) for producing a second voltage level which is higher than said voltage level; and
        means (18c) for selecting either of said first voltage level and said second voltage level as said predetermined reference voltage level in accordance with said result of the comparison.

F I G. 1

F I G. 2

F I G. 3

F I G. 4

F I G. 5

F I G. 6

FROM
DETECTOR 13

17

COMP.

TO SWITCH 14

18c

Vref₁
18a

Vref₂
18b

F I G. 7

OUTPUT SIGNAL LEVEL

Vref₂  Vref₁

INPUT SIGNAL LEVEL

F I G. 8